(19) **Europäisches Patentamt**
**European Patent Office**
**Office européen des brevets**

(11) **EP 4 239 681 B1**

(12) **EUROPEAN PATENT SPECIFICATION**

(45) Date of publication and mention
of the grant of the patent:
**06.11.2024 Bulletin 2024/45**

(21) Application number: **21885682.1**

(22) Date of filing: **30.08.2021**

(51) International Patent Classification (IPC):
**H01L 27/146** *(2006.01)*    **G01S 7/481** *(2006.01)*
**G01S 7/4863** *(2020.01)*

(52) Cooperative Patent Classification (CPC):
**H01L 27/14643; G01S 7/4816; G01S 7/4817;**
**G01S 7/4863; G01S 17/894; H01L 27/14612**

(86) International application number:
**PCT/JP2021/031721**

(87) International publication number:
**WO 2022/091563 (05.05.2022 Gazette 2022/18)**

(54) **DISTANCE IMAGE CAPTURING ELEMENT AND DISTANCE IMAGE CAPTURING DEVICE**

ENTFERNUNGSBILDAUFNAHMEELEMENT UND
ENTFERNUNGSBILDAUFNAHMEVORRICHTUNG

ÉLÉMENT ET DISPOSITIF DE CAPTURE D'IMAGE DE DISTANCE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **28.10.2020 JP 2020180563**

(43) Date of publication of application:
**06.09.2023 Bulletin 2023/36**

(73) Proprietor: **TOPPAN INC.**
**Tokyo 110-0016 (JP)**

(72) Inventors:
• **OOKUBO, Yu**
**Tokyo 110-0016 (JP)**
• **NAKAGOME, Tomohiro**
**Tokyo 110-0016 (JP)**

(74) Representative: **Plasseraud IP**
**104 Rue de Richelieu**
**CS92104**
**75080 Paris Cedex 02 (FR)**

(56) References cited:
**WO-A1-2015/118884    WO-A1-2020/196023**
**JP-A- 2017 199 855    JP-A- 2018 033 008**
**JP-A- 2020 010 328    US-A1- 2017 338 264**

**Description**

[Technical Field]

The present invention relates to range imaging devices and range imaging apparatuses.
The present application claims priority to Japanese Patent Application No. 2020-180563 filed October 28, 2020.

[Background Art]

Conventional time-of-flight (hereinafter referred to as "TOF") range imaging sensors use the known speed of light to measure the distance between the measurement device and an object based on the time of flight of light in a space (measurement space). The document WO 2020/196023 A1 is a relevant prior art.
A TOF range imaging sensor emits a pulse of light (e.g., near-infrared light or the like) to a measurement object, and uses a difference between the time at which the light pulse is emitted and the time at which the light pulse (reflected light) reflected by the object in a measurement space is returned, that is, the time of flight of light between the measurement device and the object, to measure the distance between the measurement device and the object (see, for example, Patent Literature 1).
When such a range imaging apparatus is used to accurately measure the distance to an object located at any distance, the quantity of charge carriers generated due to light reflected by the subject needs to be accurately read from pixels of the range imaging sensor by transferring the charge carriers using a plurality of gates.
In a TOF range imaging sensor, the amount of incident light is converted into charge carriers by a photoelectric conversion device, the charge carriers obtained by conversion are stored in a charge storage, and an analog voltage corresponding to the quantity of stored charge carriers is converted into a digital value by an AD converter.
The TOF range imaging sensor obtains the distance between the measurement device and an object based on an analog voltage corresponding to the quantity of charge carriers and on information from a digital value of the time of flight of light between the measurement device and the object.
In a range imaging apparatus, charge carriers generated by a photoelectric conversion device are stored in a different charge storage for each predetermined cycle, and the quantity of charge carriers stored in the respective charge storages is used to obtain a delay time from the time at which a light pulse was emitted to the time at which the light pulse reflected by a subject was returned. The range imaging apparatus uses the delay time and the speed of light to obtain the distance from the range imaging apparatus to the subject.
Thus, in order to transfer the charge carriers from the photoelectric conversion device to the charge storages, the photoelectric conversion device and the charge storages are provided with transfer gates (transistors) that transfer the charge carriers.

[Citation List]

[Patent Literature]

[PTL 1] JP 4235729 B

[Summary of the Invention]

[Technical Problem]

However, the range imaging apparatus cannot perform accurate distance measurement if the transfer gates provided between the photoelectric conversion device and the charge storages have different transfer characteristics due to the layout.
That is, if there is variation in transfer characteristics of the transfer gates, even when the same quantity of charge carriers is generated by the photoelectric conversion device, different quantities of charge carriers are stored in the charge storages during the transfer of charge carriers from the transfer gates to the charge storages.
Thus, due to the variation in the transfer characteristics of the transfer gates, the transfer of the charge carriers generated by the photoelectric conversion device to the charge storages is not performed at the same transfer efficiency, leading to distance measurement with lower accuracy.
The present invention has been made in view of such circumstances, and provides a range imaging device and a range imaging apparatus in which transfer gates for transferring charge carriers from a photoelectric conversion device to charge storages have the same transfer characteristics, charge carriers generated by the photoelectric conversion device are transferred to the charge storages at the same transfer efficiency, and a distance measured from the charge carriers stored in the charge storages is obtained with higher accuracy.

[Solution to Problem]

In order to solve the problem described above, a range imaging device of the present invention is a range imaging device including: a semiconductor substrate; and a pixel circuit formed at a surface of the semiconductor substrate, the pixel circuit including at least: a photoelectric conversion device configured to generate charge carriers based on light incident from a space targeted for measurement; charge storages configured to store at least some of the generated charge carriers; at least one transfer MOS transistor provided on a transfer path, the at least one transfer MOS transistor being configured to transfer at least some of the generated charge carriers from the photoelectric conversion device to a corresponding one of the charge storages through the transfer path; and at least one charge drainage MOS transistor provided on a drainage path, the at least one charge drainage MOS transistor being configured to drain the generated charge carriers from the photoelectric conversion device through the corresponding drainage path. The photoelectric conversion device has a rectangular shape in plan view on a surface of the photoelectric conversion device; the at least one transfer MOS transistor comprises 2M transfer MOS transistors, and the at least one charge drainage MOS transistor comprises 2N charge drainage MOS transistors, M being an integer greater than or equal to 2, N being an integer greater than or equal to 1; M transfer MOS transistors of the 2M transfer MOS transistors are arranged on each of long sides of the photoelectric conversion device symmetrically with respect to an x-axis that is parallel to the long sides and passes through a center of the photoelectric conversion device, the M transfer MOS transistors on one of the long sides facing the M transfer MOS transistors on the other of the long sides; and the 2N charge drainage MOS transistors are provided on respective short sides of the photoelectric conversion device.

The range imaging device of the present invention may be configured such that the transfer MOS transistors are arranged symmetrically with respect to a y-axis that is parallel to the short sides and passes through the center of the photoelectric conversion device.

The range imaging device of the present invention may be configured such that the charge storages are arranged symmetrically with respect to the x-axis.

The range imaging device of the present invention may be configured to further include a microlens facing a surface of the pixel circuit, the surface of the pixel circuit being arranged to receive the light, the microlens having an optical axis that is perpendicular to an entrance surface of the photoelectric conversion device and passes through the center of the entrance surface, the entrance surface being arranged to receive the light.

A range imaging apparatus of the present invention includes: a light receiving unit including one of the above range imaging devices; and a distance image processing unit configured to obtain a distance from the range imaging device to a subject based on a distance image captured by the range imaging device.

[Advantageous Effects of the Invention]

As described above, the present invention provides a range imaging device and a range imaging apparatus in which transfer gates for transferring charge carriers from a photoelectric conversion device to charge storages have the same transfer characteristics, charge carriers generated by the photoelectric conversion device are transferred to the charge storages at the same transfer efficiency, and a distance measured from the charge carriers stored in the charge storages is obtained with higher accuracy.

[Brief Description of the Drawings]

Fig. 1 is a block diagram showing a schematic configuration of a range imaging apparatus of a first embodiment of the present invention.

Fig. 2 is a block diagram showing a schematic configuration of an image sensor (range imaging sensor 32) used in a range imaging apparatus 1 of the first embodiment of the present invention.

Fig. 3 is a circuit diagram showing an example configuration of pixel circuits 321 arranged in a light receiving region 320 of the range imaging sensor 32 (range imaging device) as a solid-state image sensor used in the range imaging apparatus 1 of the first embodiment of the present invention.

Fig. 4 is a diagram showing an example arrangement (layout pattern) of transistors of the pixel circuit 321 according to the first embodiment.

Fig. 5 is a diagram showing an example of a positional relationship between the photoelectric conversion device PD, transfer transistors G, and charge drainage transistors GD in Fig. 4, according to the first embodiment.

Fig. 6A is a diagram showing a cross-sectional structure taken along line segment A-A' of a semiconductor on which the pixel circuit 321 in Fig. 5 is provided.

Fig. 6B is a diagram illustrating the transfer of charge carriers from the photoelectric conversion device PD to the floating diffusions FD performed by the transfer transistors G.

Fig. 7A is a diagram showing a cross-sectional structure taken along an x-axis of the semiconductor on which the pixel circuit 321 in Fig. 5 is provided.

Fig. 7B is a diagram illustrating the drainage of charge carriers from the photoelectric conversion device PD to a power supply VDD performed by the charge drainage transistors GD.

Fig. 8 is a diagram showing an example of a positional relationship between the photoelectric conversion device PD, transfer transistors G, and charge drainage transistors GD in each pixel circuit 321 of a second embodiment.

Fig. 9 is a diagram showing a positional relationship between the photodiode PD and a microlens ML of a pixel circuit 321, according to a third embodiment.

Fig. 10 is a plan view showing a lens array in a portion of the light receiving region 320 in which the plurality of pixel circuits 321 are arranged.

Fig. 11 is a cross-sectional view of the lens array of the pixel circuits 321 provided with the microlenses ML in Fig. 10.

Fig. 12 is a cross-sectional view of the lens array of the pixel circuits 321 provided with the microlenses ML in Fig. 10.

[Description of the Embodiments]

<First embodiment>

A first embodiment of the present invention will be described with reference to the drawings.

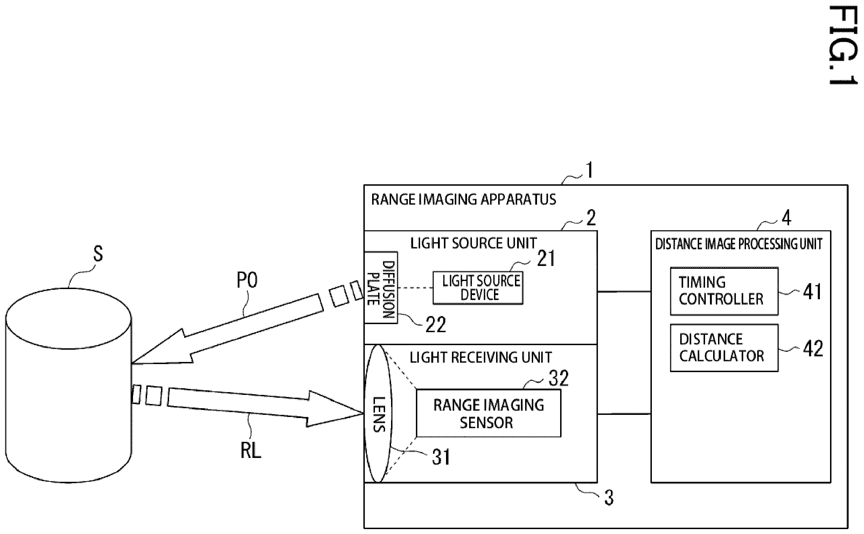

Fig. 1 is a block diagram showing a schematic configuration of a range imaging apparatus of the first embodiment of the present invention. A range imaging apparatus 1 configured as shown in Fig. 1 includes a light source unit 2, a light receiving unit 3, and a distance image processing unit 4. Fig. 1 also shows a subject S as an object for which distance measurement is performed by the range imaging apparatus 1. A range imaging device may be, for example, a range imaging sensor 32 (described later) of the light receiving unit 3.

By being controlled by the distance image processing unit 4, the light source unit 2 emits a light pulse PO to a space for which image capturing is performed and in which a subject S is present as an object for which distance measurement is performed by the range imaging apparatus 1. The light source unit 2 may be, for example, a surface-emitting semiconductor laser module such as a vertical-cavity surface-emitting laser (VCSEL). The light source unit 2 includes a light source device 21 and a diffusion plate 22.

The light source device 21 is a light source that emits laser light in the near-infrared wavelength region (e.g., in a wavelength range of 850 nm to 940 nm) as the light pulse PO with which the subject S is irradiated. The light source device 21 may be, for example, a semiconductor laser light emitting device. The light source device 21 emits pulsed laser light according to control by a timing controller 41.

The diffusion plate 22 is an optical component that diffuses laser light in the near-infrared wavelength region emitted from the light source device 21 over an area in which the subject S is irradiated with the diffused laser light. The pulsed laser light diffused by the diffusion plate 22 emerges as the light pulse PO, and the subject S is irradiated with the light pulse PO.

The light receiving unit 3 receives reflected light RL of the light pulse PO reflected by the subject S as an object for which distance measurement is performed by the range imaging apparatus 1, and outputs a pixel signal corresponding to the reflected light RL received. The light receiving unit 3 includes a lens 31 and the range imaging sensor 32.

The lens 31 is an optical lens that guides the reflected light RL incident on the lens 31 to the range imaging sensor 32. The reflected light RL incident on the lens 31 emerges toward the range imaging sensor 32, and is received by (incident on) pixel circuits provided in a light receiving region of the range imaging sensor 32.

The range imaging sensor 32 is an image sensor used in the range imaging apparatus 1. The range imaging sensor 32 includes a plurality of pixels in a two-dimensional light receiving region. Pixel circuits (pixel circuits 321) of the range imaging sensor 32 each include a single photoelectric conversion device, a plurality of charge storages corresponding to the single photoelectric conversion device, and components that each distribute charge carriers to a corresponding one of the charge storages.

The range imaging sensor 32 distributes charge carriers generated by the photoelectric conversion device to each of the charge storages, according to control by the timing controller 41. Furthermore, the range imaging sensor 32 outputs a pixel signal corresponding to the quantity of charge carriers distributed to each of the charge storages. In the range imaging sensor 32, the plurality of pixel circuits are arranged in a two-dimensional matrix, and the range imaging sensor 32 outputs each pixel signal for one frame for the individual pixel circuits.

The distance image processing unit 4 controls the range imaging apparatus 1 to calculate the distance to the subject S. The distance image processing unit 4 includes the timing controller 41 and a distance calculator 42.

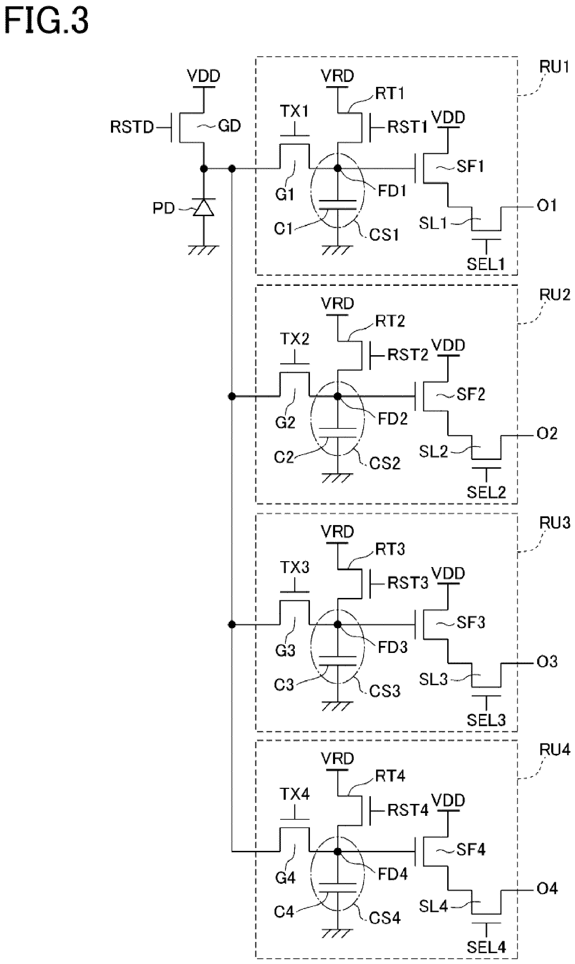

The timing controller 41 controls the timing of outputting various control signals required for distance measurement. The various control signals include, for example, a signal for controlling emission of the light pulse PO, a signal for distributing the reflected light RL to the plurality of charge storages, and a signal for controlling the number of distributions per frame. The number of distributions is the number of repetitions of the process of distributing charge carriers to charge storages CS (see Fig. 3).

The distance calculator 42 outputs distance information obtained by calculating the distance to the subject S, based on the pixel signal output from the range imaging sensor 32. The distance calculator 42 calculates a delay time Td from the time at which the light pulse PO is emitted to the time at which the reflected light RL is received, based on the quantity of charge carriers stored in the plurality of charge storages CS. The distance calculator 42 calculates the distance from the range imaging apparatus 1 to the subject S according to the calculated delay time Td.

With such a configuration, in the range imaging apparatus 1, the light pulse PO in the near-infrared wavelength region emitted from the light source unit 2 to the subject S is reflected by the subject S, and the reflected light RL is received by the light receiving unit 3, and the distance image processing unit 4 outputs distance information obtained by measuring the distance between the subject S and the range imaging apparatus 1.

Fig. 1 shows the range imaging apparatus 1 in which the distance image processing unit 4 is included; however, the distance image processing unit 4 may be a component provided outside the range imaging apparatus 1.

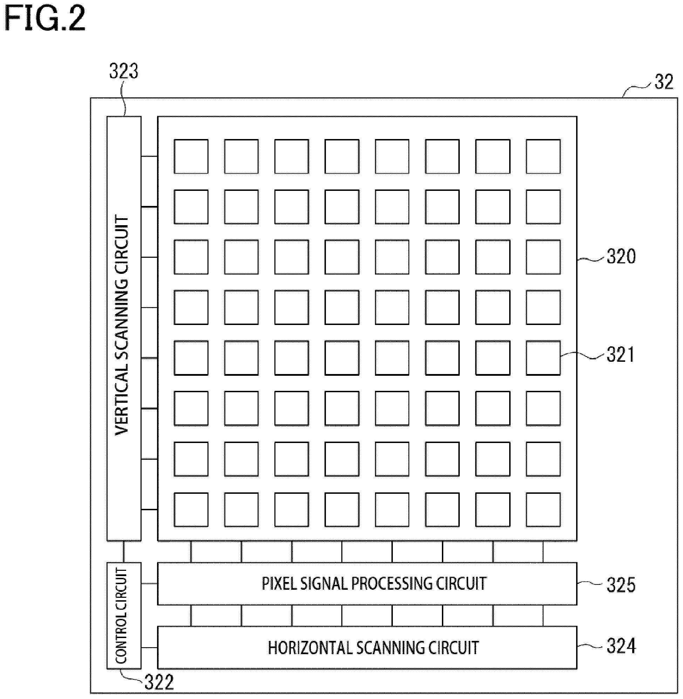

Next, a configuration of the range imaging sensor 32 used as an image sensor in the range imaging apparatus 1 will be described. Fig. 2 is a block diagram showing a schematic configuration of the image sensor (range imaging sensor 32) used in the range imaging apparatus 1 of the first embodiment of the present invention.

As shown in Fig. 2, the range imaging sensor 32 includes, for example, the light receiving region 320 in which the plurality of pixel circuits 321 are arranged, a control circuit 322, a vertical scanning circuit 323 that performs distribution operation, a horizontal scanning circuit 324, and a pixel signal processing circuit 325.

The light receiving region 320 is a region in which the plurality of pixel circuits 321 are arranged. Fig. 2 shows an example in which the pixel circuits 321 are arranged in a two-dimensional matrix with 8 rows and 8 columns. The pixel circuits 321 store charge carriers corresponding to the amount of light received. The control circuit 322 controls the operation of the components of the range imaging sensor 32, for example, according to instructions from the timing controller 41 of the distance image processing unit 4.

The vertical scanning circuit 323 is a circuit that controls, for each row, the pixel circuits 321 arranged in the light receiving region 320, according to control by the control circuit 322. The vertical scanning circuit 323 causes the pixel circuits 321 to output, to the pixel signal processing circuit 325, each voltage signal corresponding to the quantity of charge carriers stored in the individual charge storages CS of the pixel circuits 321.

The pixel signal processing circuit 325 performs predetermined signal processing (e.g., noise suppression processing, A/D conversion processing, etc.) to the voltage signals output from the pixel circuits 321 in each row, according to control by the control circuit 322.

The horizontal scanning circuit 324 is a circuit that causes a signal output from the pixel signal processing circuit 325 to be sequentially output in a time series manner, according to control by the control circuit 322. Thus, a pixel signal corresponding to the quantity of charge carriers stored for one frame is sequentially output to the distance image processing unit 4. The following description assumes that the pixel signal processing circuit 325 performs A/D conversion processing, and the pixel signal is a digital signal.

A configuration of the pixel circuits 321 arranged in the light receiving region 320 of the range imaging sensor 32 will be described. Fig. 3 is a circuit diagram showing an example configuration of the pixel circuits 321 arranged in the light receiving region 320 of the range imaging sensor 32 (range imaging device) as a solid-state image sensor used in the range imaging apparatus 1 of the first embodiment of the present invention. The pixel circuit 321 in Fig. 3 is a configuration example including four pixel signal reading units.

The pixel circuit 321 includes a single photoelectric conversion device PD, charge drainage transistors GD (GD1 and GD2 described later), and four pixel signal reading units RU (RU1 to RU4) each of which outputs a voltage signal from the corresponding output terminal O. The pixel signal reading units RU each include a transfer transistor G, a floating diffusion FD, a charge storage capacitor C, a reset transistor RT, a source follower transistor SF, and a selection transistor SL. The floating diffusion FD and the charge storage capacitor C constitute a charge storage CS.

In the pixel circuit 321 shown in Fig. 3, the pixel signal reading unit RU1 that outputs a voltage signal from an output terminal O1 includes a transfer transistor G1 (transfer MOS transistor), a floating diffusion FD1, a charge storage capacitor C1, a reset transistor RT1, a source follower transistor SF1, and a selection transistor SL1. In the pixel signal reading unit RU1, the floating diffusion FD1 and the charge storage capacitor C1 constitute a charge storage CS1. The pixel signal reading units RU2, RU3, and RU4 also have the same configuration.

The photoelectric conversion device PD is an embedded photodiode that performs photoelectric conversion of incident light to generate charge carriers corresponding to the incident light and that stores the generated charge carriers. In the present embodiment, incident light is incident from a space to be measured.

In the pixel circuits 321, the charge carriers generated through photoelectric conversion of the incident light by the photoelectric conversion device PD are distributed to each of four charge storages CS (CS1 to CS4), and each voltage signal corresponding to the quantity of charge carriers distributed is output to the pixel signal processing circuit 325.

The configuration of the pixel circuits arranged in the range imaging sensor 32 is not limited to the configuration including the four pixel signal reading units RU (RU1 to RU4) as shown in Fig. 3. The pixel circuits may include 2M (M is an integer, M ≥ 2) or more pixel signal reading units RU. That is, the pixel circuits may include 2M (M is an integer, M ≥ 2) or more transfer transistors G.

When the pixel circuits 321 of the range imaging apparatus 1 are driven, the light pulse PO is emitted for an emission time To, and after the delay time Td, the reflected light RL is received by the range imaging sensor 32. In synchronization with emission of the light pulse PO, the vertical scanning circuit 323 transfers the charge carriers generated by the photoelectric conversion device PD to the charge storages CS1, CS2, CS3, and CS4 in this order to cause the charge carriers to be stored in the charge storages.

At this time, the vertical scanning circuit 323 causes the transfer transistor G1 to be in an ON state. The transfer transistor G1 is provided on a transfer path through which charge carriers are transferred from the photoelectric conversion device PD to the charge storage CS1. Thus, charge carriers generated through photoelectric conversion by the photoelectric conversion device PD are stored in the charge storage CS1 via the transfer transistor G1. Then, the vertical scanning circuit 323 causes the transfer transistor G1 to be in an OFF state. This stops the transfer of charge carriers to the charge storage CS1. Thus, the vertical scanning circuit 323 causes charge carriers to be stored in the charge storage CS1. The same applies to the charge storages CS2, CS3, and CS4.

In this case, storage cycles are repeated in a charge storage period in which charge carriers are distributed to the charge storages CS. In the storage cycles, storage driving signals TX1, TX2, TX3, and TX4 are supplied to the transfer transistors G1, G2, G3, and G4, respectively.

Charge carriers corresponding to the incident light are transferred from the photoelectric conversion device PD to the charge storages CS1, CS2, CS3, and CS4 via the transfer transistors G1, G2, G3, and G4, respectively. A plurality of storage cycles are repeated in the charge storage period.

Thus, for the storage cycles of the charge storages CS1, CS2, CS3, and CS4 in the charge storage period, charge carriers are stored in the charge storages CS1, CS2, CS3, and CS4, respectively.

When the storage cycles of the charge storages CS1, CS2, CS3, and CS4 are repeated, after the transfer of charge carriers to the charge storage CS4 is ended, the vertical scanning circuit 323 turns on the charge drainage transistor GD provided on a discharge path through which the charge carriers are discharged from the photoelectric conversion device PD.

Thus, before the storage cycle of the charge storage CS1 is started, the charge drainage transistor GD removes the charge carriers generated by the photoelectric conversion device PD after the preceding storage cycle of the charge storage CS4 (i.e., resets the photoelectric conversion device PD).

The vertical scanning circuit 323 causes, for each row (the array in the lateral direction) of the pixel circuits 321, each of all the pixel circuits 321 arranged in the light receiving region 320 to sequentially output a voltage signal to the pixel signal processing circuit 325.

The pixel signal processing circuit 325 performs signal processing such as A/D conversion processing to each of the input voltage signals, and outputs the voltage signal subjected to the signal processing to the horizontal scanning circuit 324.

The horizontal scanning circuit 324 causes the voltage signal subjected to the signal processing to be sequentially output to the distance calculator 42 in the order of the rows in the light receiving region 320.

The vertical scanning circuit 323 repeatedly performs, over one frame, the storage of charge carriers in the charge storages CS and the removal of the charge carriers generated through photoelectric conversion by the photoelectric conversion device PD as described above. Thus, the charge carriers corresponding to the amount of light received by the range imaging apparatus 1 during a predetermined time period are stored in each of the charge storages CS. The horizontal scanning circuit 324 outputs, to the distance calculator 42, each electrical signal corresponding to the quantity of charge carriers for one frame stored in the individual charge storages CS.

Due to the relationship between the timing at which the light pulse PO is emitted and the timing at which charge carriers are stored in each of the charge storages CS (CS1 to CS4), the quantity of charge carriers corresponding to an external light component such as background light before the emission of the light pulse PO is held in the charge storage CS1. Furthermore, the quantity of charge carriers corresponding to the reflected light RL and the external light component is distributed to the charge storages CS2, CS3, and CS4 and held therein. The distribution (distribution ratio) between the quantity of charge carriers distributed to the charge storage CS2 and the quantity of charge carriers distributed to the charge storage CS3 or the distribution ratio between the quantity of charge carriers distributed to the charge storage CS3 and the quantity of charge carriers distributed to the charge storage CS4 is a ratio corresponding to the delay time Td from the time at which the light pulse PO is emitted to the time at which the light pulse PO is incident on the range imaging apparatus 1 after being reflected by the subject S.

The distance calculator 42 uses this principle to calculate the delay time Td by the following formula (1) or (2).

$$Td = To \times (Q3 - Q1)/(Q2 + Q3 - 2 \times Q1) \dots (1)$$

$$Td = To + To \times (Q4 - Q1)/(Q3 + Q4 - 2 \times Q1) \dots (2)$$

Here, To represents the period during which the light pulse PO is emitted, Q1 represents the quantity of charge carriers stored in the charge storage CS1, Q2 represents the quantity of charge carriers stored in the charge storage CS2, Q3 represents the quantity of charge carriers stored in the charge storage CS3, and Q4 represents the quantity of charge carriers stored in the charge storage CS4. For example, the distance calculator 42 uses the formula (1) to calculate the delay time Td when Q4 = Q1, and uses the formula (2) to calculate the delay time Td when Q2 = Q1.

In the formula (1), charge carriers generated from the reflected light are stored in the charge storages CS2 and CS3, but are not stored in the charge storage CS4. On the other hand, in the formula (2), charge carriers generated from the reflected light are stored in the charge storages CS3 and CS4, but are not stored in the charge storage CS2.

In the formula (1) or (2), the quantity of charge carriers corresponding to the external light component of the quantity of charge carriers stored in the charge storages CS2, CS3, and CS4 is assumed to be equal to the quantity of charge carriers stored in the charge storage CS1.

The distance calculator 42 multiplies the delay time Td obtained from the formula (1) or (2) by the speed of light (speed) to calculate the round-trip distance between the range imaging sensor 32 and the subject S.

Then, the distance calculator 42 calculates 1/2 of the calculated round-trip distance to obtain the distance from the range imaging sensor 32 to the subject S.

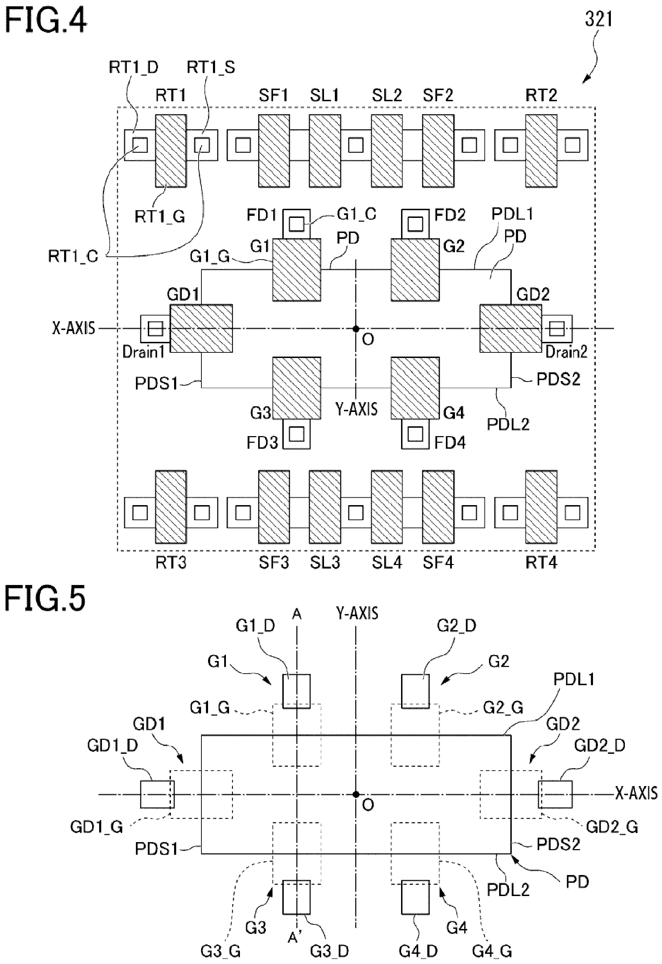

Fig. 4 is a diagram showing an example arrangement (layout pattern) of the transistors of the pixel circuits 321 according to the present embodiment.

The layout pattern in Fig. 4 is a layout pattern of the pixel circuit 321 in Fig. 3 (i.e., the pixel circuits 321 in Fig. 2).

Fig. 4 shows an arrangement pattern of the transfer transistors G1, G2, G3, and G4, the source follower transistors SF1, SF2, SF3, and SF4, the selection transistors SL1, SL2, SL3, and SL4, the reset transistors RT1, RT2, RT3, and RT4, the charge drainage transistors GD1 and GD2, and the photoelectric conversion device PD. All the transistors described above are n-channel MOS transistors provided at a p-type semiconductor substrate.

For example, the reset transistor RT1 is composed of a drain RT1_D (n-type diffusion layer (diffusion layer of n-type impurities)), a source RT1_S (n-type diffusion layer), and a gate RT1_G at the p-type semiconductor substrate.

A contact RT1_C is a pattern indicating a contact that is provided in each of the diffusion layers, that is, the drain RT1_D (n-type diffusion layer) and the source RT1_S (n-type diffusion layer) of the reset transistor RT1, and that is connected to a wire (not shown). The transfer transistors G1 to G4, the source follower transistors SF1 to SF4, the selection transistors SL1 to SL4, the reset transistors RT2 to RT4, and the charge drainage transistors GD1 and GD2 also have the same configuration.

The photoelectric conversion device PD has a rectangular shape, and has a long side PDL1, PDL2 facing the long side PDL1 in parallel, a short side PDS1, PDS2 facing the short side PDS1 in parallel.

In particular, configurations of the transfer transistors G1 to G4 and the charge drainage transistors GD1 and GD2 will be described later.

The transfer transistor G1 is composed of the floating diffusion FD1 as a drain, a gate G1_G, and a source (n-type diffusion layer of the photoelectric conversion device PD). The floating diffusion FD1 is a diffusion layer (n-type diffusion layer) as a drain of the transfer transistor G1, and stores the charge carriers from the photoelectric conversion device PD.

A drain G1_D is connected, by a contact G1_C via a wire (not shown), to each of a gate SF1_G of the source follower transistor SF1 and the source RT1_S of the reset transistor RT1. The transfer transistors G2, G3, and G4 also have the same configuration as the transfer transistor G1.

Fig. 4 shows an arrangement of the transistors of the pixel circuits 321 at the semiconductor substrate. In Fig. 4, a wiring pattern and the charge storage capacitors (C1 to C4) are omitted. Thus, the charge storages CS1, CS2, CS3, and CS4 are located at the positions of the floating diffusions FD1, FD2, FD3, and FD4, respectively.

The floating diffusions FD1 and FD2 and the respective floating diffusions FD3 and FD4 are arranged symmetrically with respect to an x-axis.

In the rectangular pattern of the photoelectric conversion device PD, the x-axis is an axis that is perpendicular to the short side PDS1 (and the short side PDS2) of the rectangle (i.e., parallel to the long sides PDL1 and PDL2 of the rectangle) and that passes through a center O of the rectangle. A y-axis is an axis that is perpendicular to the x-axis, that is, perpendicular to the long side PDL1 (and the long side PDL2) of the rectangle (i.e., parallel to the short sides PDS1 and PDS2 of the rectangle), and that passes through the center O of the rectangle.

The reset transistors RT1 and RT2 and the respective reset transistors RT3 and RT4 are arranged symmetrically with respect to the x-axis.

The source follower transistors SF1 and SF2 and the respective source follower transistors SF3 and SF4 are arranged symmetrically with respect to the x-axis.

The selection transistors SL1 and SL2 and the respective selection transistors SL3 and SL4 are arranged symmetrically with respect to the x-axis.

Fig. 5 is a diagram showing an example of a positional relationship between the photoelectric conversion device PD, the transfer transistors G, and the charge drainage transistors GD in Fig. 4.

Fig. 5 shows a positional relationship of the transfer transistors G1, G2, G3, and G4 and the charge drainage transistors GD1 and GD2 with respect to the photoelectric conversion device PD.

The transfer transistors G1 and G2 are provided at the long side PDL1 of the photoelectric conversion device PD, and include the floating diffusions FD1 and FD2, respectively, as a drain, and the n-type diffusion layer of the photoelectric conversion device PD as a source.

The transfer transistors G3 and G4 are provided at the long side PDL2 of the photoelectric conversion device PD, and include the floating diffusions FD3 and FD4, respectively, as a drain, and the n-type diffusion layer of the photoelectric conversion device PD as a source.

The transfer transistors G1 and G3 are arranged symmetrically with respect to the x-axis. That is, the gate G1_G of the transfer transistor G1 and the gate G3_G of the transfer transistor G3 are arranged symmetrically with respect to the x-axis.

Similarly, the transfer transistors G2 and G4 are arranged symmetrically with respect to the x-axis. That is, the gate G2_G of the transfer transistor G2 and the gate G4_G of the transfer transistor G4 are arranged symmetrically with respect to the x-axis.

The transfer transistors G1 and G2 are arranged symmetrically with respect to the y-axis. That is, the gates of the transfer transistors G1 and G2 are arranged symmetrically with respect to the y-axis.

Similarly, the transfer transistors G3 and G4 are arranged symmetrically with respect to the y-axis. That is, the gates of the transfer transistors G3 and G4 are arranged symmetrically with respect to the y-axis.

As described above, the transfer transistors G1, G2, G3, and G4 are located at the same distance from the x-axis, and are also located at the same distance from the center O of the photoelectric conversion device PD.

The transfer transistors G1 to G4 have the same size (the same channel length and width), and have the same transistor characteristics.

The charge drainage transistor GD1 is provided at the short side PDS1, and includes the n-type diffusion layer of the photoelectric conversion device PD as a source.

Similarly, the charge drainage transistor GD2 is provided at the short side PDS2, and includes the n-type diffusion layer of the photoelectric conversion device PD as a source.

The charge drainage transistors GD1 and GD2 are arranged symmetrically with respect to the y-axis. That is, the gates of the charge drainage transistors GD1 and GD2 are arranged symmetrically with respect to the y-axis.

As described above, the charge drainage transistors GD1 and GD2 are located at the same distance from the y-axis, and are also located at the same distance from the center O of the photoelectric conversion device PD.

The charge drainage transistors GD1 and GD2 may have the same size and the same transistor characteristics, or may have different transistor characteristics.

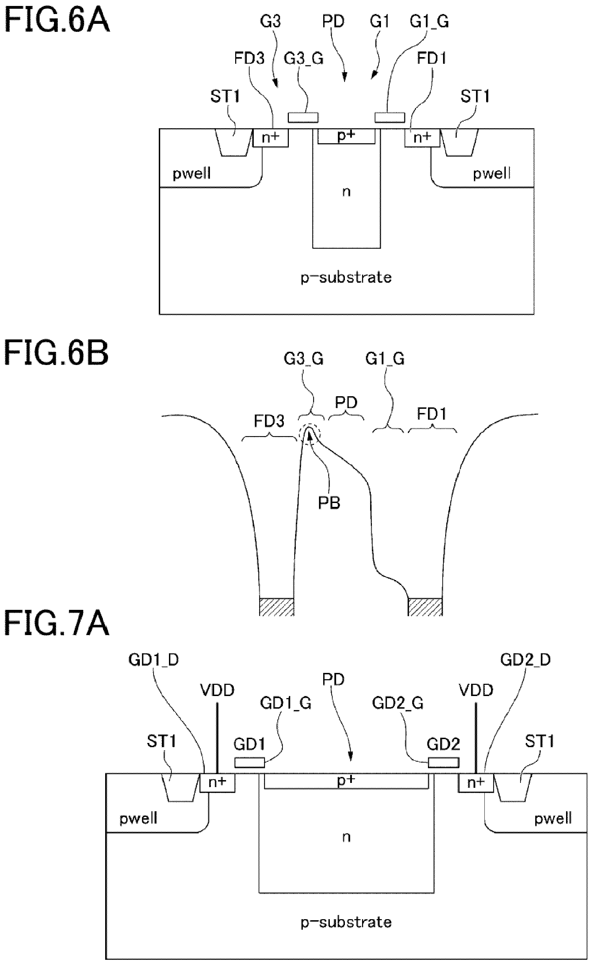

Figs. 6A and 6B are each a diagram illustrating the transfer of charge carriers from the photoelectric conversion device PD to the floating diffusions FD performed by the transfer transistors G.

Fig. 6A shows a cross-sectional structure taken along line segment A-A' of the semiconductor on which the pixel circuit 321 in Fig. 5 is provided.

The photoelectric conversion device PD may be, for example, an embedded photodiode having a p+ diffusion layer (diffusion layer of p-type impurities) as a surface protective layer at its surface.

The transfer transistor G1 includes the n-type diffusion layer of the photoelectric conversion device PD as a source, and an n+ diffusion layer of the floating diffusion FD1 as a drain.

The n+ diffusion layer of the floating diffusion FD1 is adjacent to an STI (shallow trench isolation) and a p-well (p-type diffusion layer) for preventing the outflow (discharge) of charge carriers (for preventing current leakage) from the n+ diffusion layer.

The transfer transistor G3 includes the n-type diffusion layer of the photoelectric conversion device PD as a source, and an n+ diffusion layer of the floating diffusion FD3 as a drain.

The n+ diffusion layer of the floating diffusion FD3 is adjacent to an STI and a p-well for preventing current leakage from the n+ diffusion layer.

In response to application of a gate voltage at an "H" level to the gate G1_G, the transfer transistor G1 transfers charge carriers (electrons) generated by the photoelectric conversion device PD to the floating diffusion FD1 as a drain. The floating diffusion FD1 stores the charge carriers transferred from the transfer transistor G1.

Similarly, in response to application of a gate voltage at the "H" level to the gate G3_G, the transfer transistor G3 transfers charge carriers (electrons) generated by the photoelectric conversion device PD to the floating diffusion FD3 as a drain. The floating diffusion FD3 stores the charge carriers transferred from the transfer transistor G3.

Fig. 6B shows a potential state in the regions of the transfer transistor G1, the photoelectric conversion device PD, and the transfer transistor G3 shown in Fig. 6A. In Fig. 6B, the horizontal axis indicates a position in the regions, and the vertical axis indicates a potential level (the potential is higher at a lower position).

Fig. 6B shows a potential state when a gate voltage at the "H" level is applied to the gate G1_G of the transfer transistor G1 and a gate voltage at an "L" level is applied to the gate G3_G of the transfer transistor G3.

The gate G3_G of the transfer transistor G3 is at the "L" level; thus, a potential barrier PB is formed in the region of the gate G3_G, and no charge carriers are transferred from the photoelectric conversion device PD to the floating diffusion FD3 as a drain of the transfer transistor G3 (no electrons flow to the drain).

On the other hand, the gate G1_G of the transfer transistor G1 is at the "H" level; thus, the potential is high (no potential barrier is formed) in the region of the gate G1_G, and charge carriers are transferred from the photoelectric conversion device PD to the floating diffusion FD1 as a drain of the transfer transistor G1 (the electrons flow to the drain).

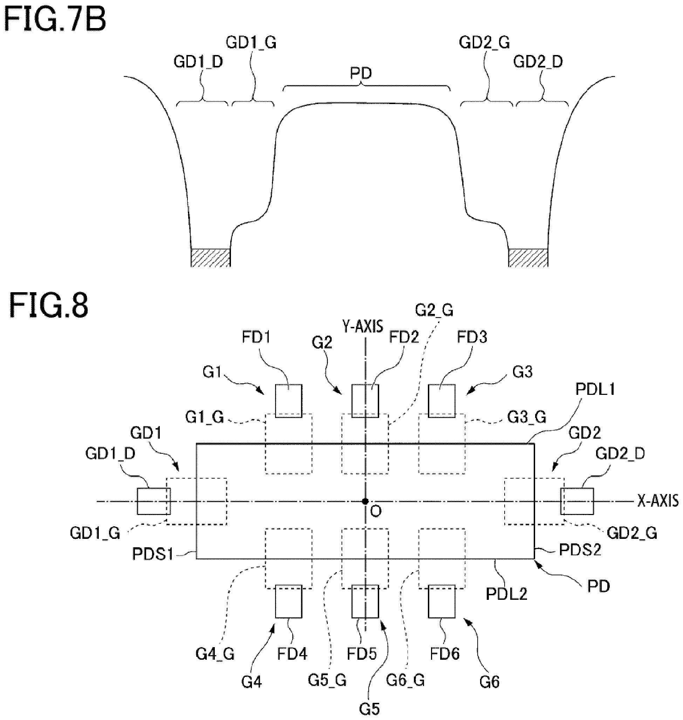

Fig. 7A and 7B are each a diagram illustrating the drainage of charge carriers from the photoelectric conversion device PD to a power supply VDD performed by the charge drainage transistors GD.

Fig. 7A shows a cross-sectional structure taken along the x-axis of the semiconductor on which the pixel circuit 321 in Fig. 5 is provided.

The charge drainage transistor GD1 includes, as a source, the n-type diffusion layer of the photoelectric conversion device PD, and, as a drain GD1_D, an n+ diffusion layer connected to the power supply VDD.

The n+ diffusion layer of the drain GD2_D is adjacent to an STI and a p-well for preventing current leakage from the n+ diffusion layer.

The charge drainage transistor GD2 includes, as a source, the n-type diffusion layer of the photoelectric conversion device PD, and, as a drain GD2_D, an n+ diffusion layer connected to the power supply VDD.

The n+ diffusion layer of the drain GD2_D is adjacent to an STI and a p-well for preventing current leakage from the n+ diffusion layer.

In response to application of a gate voltage at the "H" level to a gate GD1_G, the charge drainage transistor GD1 transfers the charge carriers (electrons) generated by the photoelectric conversion device PD to the drain GD1_D (discharges the charge carriers of the photoelectric conversion device PD to the power supply VDD).

Similarly, in response to application of a gate voltage at the "H" level to a gate GD2_G, the charge drainage transistor GD2 transfers the charge carriers generated by the photoelectric conversion device PD to the drain GD2_D.

Fig. 7B shows a potential state in the regions of the charge drainage transistor GD1, the photoelectric conversion device PD, and the charge drainage transistor GD2 shown in Fig. 7A. In Fig. 7B, the horizontal axis indicates a position in the regions, and the vertical axis indicates a potential level (the potential is higher at a lower position).

Fig. 7B shows a potential state when a gate voltage at the "H" level is applied to the gate GD1_G of the charge drainage transistor GD1 and similarly, a gate voltage at the "H" level is applied to the gate GD2_G of the charge drainage transistor GD2.

The gate GD1_G of the charge drainage transistor GD1 is at the "H" level; thus, the potential is high (no potential barrier is formed) in the region of the gate GD1_G, and the charge carriers are transferred from the photoelectric conversion device PD to the drain GD1_D of the charge drainage transistor GD1 (the electrons are discharged to the power supply VDD connected to the drain GD1_D).

On the other hand, the gate GD2_G of the charge drainage transistor GD2 is at the "H" level; thus, as in the gate GD1_G of the charge drainage transistor GD1, no potential barrier is formed in the region of the gate GD2_G, and the charge carriers are transferred from the photoelectric conversion device PD to the drain GD2_D of the charge drainage transistor GD2.

In comparison between the potential states in Figs. 6B and 7B, the slope of the increase in potential (gradient of the potential) in the regions of the gate G1_G of the transfer transistor G1 and the gate G3_G of the transfer transistor G3 is steeper than the slope of the increase in potential in the regions of the gate GD1_G of the charge drainage transistor GD1 and the gate GD2_G of the charge drainage transistor GD2.

This is because the transfer transistors G1 and G3 are provided at the long side of the photoelectric conversion device PD; thus, the distance from the center O of the photoelectric conversion device PD to the transfer transistors G1 and G3 is smaller than the distance from the center O of the photoelectric conversion device PD to the charge drainage transistors GD1 and GD2, which are provided at the short side of the photoelectric conversion device PD.

Thus, the width of the diffusion layer in the y-axis direction of the photoelectric conversion device PD is smaller, and an electric field extending in the diffusion layer from each of the transfer transistors G1 and G3 toward the center O of the photoelectric conversion device PD has a higher intensity than an electric field extending in the diffusion layer from each of the charge drainage transistors GD1 and GD2 toward the center O of the photoelectric conversion device PD.

Due to the difference in the intensity of the electric field in the diffusion layer, the slope of the increase in potential in the regions of the gates G1_G and G3_G is steeper than the slope of the increase in potential in the regions of the gates GD1_G and GD2_G.

The transfer transistors G2 and G4 are also provided at the respective long sides of the photoelectric conversion device PD; thus, as in the transfer transistors G1 and G3, the slope of the increase in potential in the regions of the gates G2_G and G4_G is steeper than in the regions of the charge drainage transistors GD1 and GD2.

Therefore, in the present embodiment, the slope of the increase in potential in the transfer transistors G is steeper than the slope of the increase in potential in the charge drainage transistors GD; thus, charge carriers generated by the photoelectric conversion device PD are more easily transferred via the transfer transistors G. This allows the transfer transistors G to transfer charge carriers to the floating diffusions FD at a high speed.

The charge drainage transistors GD, that is, the two charge drainage transistors (GD1, GD2), transfer the charge carriers to the drains GD_D over a sufficiently long period of time compared with the transfer transistors G; thus, the charge drainage transistors GD perform the discharging process without problems even when the slope of the increase in potential in the charge drainage transistors GD is more gradual than in the transfer transistors G.

In the present embodiment, the distance from each of the gate G1_G of the transfer transistor G1, the gate G2_G of the transfer transistor G2, the gate G3_G of the transfer transistor G3, and the gate G4_G of the transfer transistor G4 to the center O of the photoelectric conversion device PD is the same; thus, the slope of the change in potential (the slope of the increase in potential) is the same in the gates G1_G, G2_G, G3_G, and G4_G, allowing the transfer transistors G1, G2, G3, and G4 to have the same transfer efficiency and the same transfer characteristics. This enables the transfer transistors G1, G2, G3, and G4 to highly accurately transfer charge carriers generated by the photoelectric conversion device PD to the floating diffusions FD1, FD2, FD3, and FD4, respectively.

That is, when the transfer transistors G1, G2, G3, and G4 respectively transfer, for example, the same quantity of charge carriers from the photoelectric conversion device PD to the floating diffusions FD1, FD2, FD3, and FD4, the same quantity of charge carriers is stored in the floating diffusions FD1, FD2, FD3, and FD4.

Therefore, in the present embodiment, charge carriers generated by the photoelectric conversion device PD can be stored in the charge storages CS 1 to CS4 at the same transfer efficiency (with the same transfer characteristics); thus, the distance between a subject and the range imaging apparatus (range imaging device) can be obtained with high accuracy by the formulas (1) and (2) using the quantity of charge carriers stored in the charge storages CS1 to CS4.

<Second embodiment>

A second embodiment of the present invention will be described with reference to the drawings.

The second embodiment is a range imaging device (range imaging sensor 32) of the range imaging apparatus having the same configuration as that in Fig. 2, and is configured to further include pixel signal reading units RU5 and RU6 in addition to the pixel signal reading units RU1 to RU4 of the configuration in Fig. 3.

Thus, the configuration of the second embodiment further includes floating diffusions FD5 and FD6, transfer transistors G5 and G6, charge drainage transistors GD5 and GD6, reset transistors RT5 and RT6, source follower transistors SF5 and SF6, and selection transistors SL5 and SL6 in addition to the configuration of the first embodiment.

In the second embodiment, the distance between a subject and the range imaging apparatus is obtained using the quantity of charge carriers stored in each of the charge storages CS1 to CS6, in the same manner as in the first embodiment.

However, the distance calculator 42 also uses the following formulas (3) and (4) to calculate the delay time Td in addition to the formulas (1) and (2) described above.

$$Td = 2 \times To + To \times (Q5 - Q1)/(Q4 + Q5 - 2 \times Q1) \dots (3)$$

$$Td = 3 \times To + To \times (Q6 - Q1)/(Q5 + Q6 - 2 \times Q1) \dots (4)$$

Here, To represents the period during which the light pulse PO is emitted, Q1 represents the quantity of charge carriers stored in the charge storage CS1, Q4 represents the quantity of charge carriers stored in the charge storage CS4, Q5 represents the quantity of charge carriers stored in the charge storage CS5, and Q6 represents the quantity of charge carriers stored in the charge storage CS6.

For example, the distance calculator 42 uses the formula (1) to calculate the delay time Td when Q4 = Q5 = Q6 = Q1, uses the formula (2) to calculate the delay time Td when Q2 = Q5 = Q6 = Q1, uses the formula (3) to calculate the delay time Td when Q2 = Q3 = Q6 = Q1, and uses the formula (4) to calculate the delay time Td when Q2 = Q3 = Q4 = Q1.

Fig. 8 is a diagram showing an example of a positional relationship between the photoelectric conversion device PD, the transfer transistors G, and the charge drainage transistors GD in the pixel circuits 321 of the present embodiment.

Fig. 8 shows a positional relationship of the transfer transistors G1, G2, G3, G4, G5, and G6 and the charge drainage transistors GD1 and GD2 with respect to the photoelectric conversion device PD.

The transfer transistors G1, G2, G3, G4, G5, and G6, the source follower transistors SF1, SF2, SF3, SF4, SF5, and SF6, the selection transistors SL1, SL2, SL3, SL4, SL5, and SL6, the reset transistors RT1, RT2, RT3, RT4, RT5, and RT6, and the charge drainage transistors are all n-channel MOS transistors provided at a p-type semiconductor substrate.

Although not shown, as in the first embodiment, the floating diffusions FD1 and FD4 are arranged symmetrically with respect to the x-axis, the floating diffusions FD2 and FD5 are arranged symmetrically with respect to the x-axis, and the floating diffusions FD3 and FD6 are arranged symmetrically with respect to the x-axis.

The reset transistors RT1 and RT4 are arranged symmetrically with respect to the x-axis, the reset transistors RT2 and RT5 are arranged symmetrically with respect to the x-axis, and the reset transistors RT3 and RT6 are arranged symmetrically with respect to the x-axis.

The source follower transistors SF1 and SF4 are arranged symmetrically with respect to the x-axis, the source follower transistors SF2 and SF5 are arranged symmetrically with respect to the x-axis, and the source follower transistors SF3 and SF6 are arranged symmetrically with respect to the x-axis.

The selection transistors SL1 and SL4 are arranged symmetrically with respect to the x-axis, the selection transistors SL2 and SL5 are arranged symmetrically with respect to the x-axis, and the selection transistors SL3 and SL6 are arranged symmetrically with respect to the x-axis.

As in the first embodiment, the photoelectric conversion device PD has a rectangular shape, and has the long side PDL1, the PDL2 that faces the long side PDL1 in parallel, the short side PDS1, and the PDS2 that faces the short side PDS1 in parallel.

The transfer transistors G1, G2, and G3 are provided at the long side PDL1, and each include the n-type diffusion layer of the photoelectric conversion device PD as a source.

The transfer transistors G4, G5, and G6 are provided at the long side PDL2, and each include the n-type diffusion layer of the photoelectric conversion device PD as a source.

The transfer transistors G1 and G4 are arranged symmetrically with respect to the x-axis passing through the center O of the photoelectric conversion device PD (the same as the x-axis of the first embodiment). That is, the gates of the transfer transistors G1 and G4 are arranged symmetrically with respect to the x-axis.

Similarly, the transfer transistors G2 and G5 are arranged symmetrically with respect to the x-axis. That is, the gates of the transfer transistors G2 and G5 are arranged symmetrically with respect to the x-axis.

The transfer transistors G3 and G6 are arranged symmetrically with respect to the x-axis. That is, the gates of the transfer transistors G3 and G6 are arranged symmetrically with respect to the x-axis.

The transfer transistors G1 to G6 have the same size (the same channel length and width), and have the same transistor characteristics.

The transfer transistors G1 and G3 are arranged symmetrically with respect to the y-axis passing through the center O of the photoelectric conversion device PD (the same as the y-axis of the first embodiment). That is, the gates of the transfer transistors G1 and G3 are arranged symmetrically with respect to the y-axis.

Similarly, the transfer transistors G4 and G6 are arranged symmetrically with respect to the y-axis. That is, the gates of the transfer transistors G4 and G6 are arranged symmetrically with respect to the y-axis.

The transfer transistors G1 and G3 are provided so that the center axes of the transfer transistors G1 and G3 parallel to the short side PDS1 (PDS2) are parallel to each other.

Thus, the distance between the transfer transistors G1 and G2, the distance between the transfer transistors G3 and G2, the distance between the transfer transistors G4 and G5, and the distance between the transfer transistors G6 and G5 are the same.

As described above, the transfer transistors G1, G2, G3, G4, G5, and G6 are located at the same distance from the x-axis.

The transfer transistors G1, G3, G4, and G6 are located at the same distance from the center O of the photoelectric conversion device PD.

The charge drainage transistor GD1 is provided at the short side PDS1, and includes the n-type diffusion layer of the photoelectric conversion device PD as a source.

Similarly, the charge drainage transistor GD2 is provided at the short side PDS2, and includes the n-type diffusion layer of the photoelectric conversion device PD as a source.

The charge drainage transistors GD1 and GD2 are arranged symmetrically with respect to the y-axis. That is, the gates of the charge drainage transistors GD1 and GD2 are arranged symmetrically with respect to the y-axis.

The charge drainage transistors GD1 and GD2 may have the same size and the same transistor characteristics, or may have different transistor characteristics.

As described above, the charge drainage transistors GD1 and GD2 are located at the same distance from the y-axis, and are also located at the same distance from the center O of the photoelectric conversion device PD.

As described above, due to the configuration of the second embodiment being similar to the configuration of the first embodiment, the transfer transistors G1 to G6 are provided at the long sides of the photoelectric conversion device PD; thus, the distance from the center O of the photoelectric conversion device PD to the transfer transistors G1 to G6 is smaller than the distance from the center O of the photoelectric conversion device PD to the charge drainage transistors GD1 and GD2, which are provided at the short sides of the photoelectric conversion device PD.

Therefore, the width of the diffusion layer in the y-axis direction of the photoelectric conversion device PD is smaller, and an electric field extending in the diffusion layer of the photoelectric conversion device PD from each of the transfer transistors G1 to G6 has a higher intensity than an electric field extending in the diffusion layer of the photoelectric conversion device PD from each of the charge drainage transistors GD1 and GD2.

Thus, as in the first embodiment, due to the difference in the intensity of the electric field in the diffusion layer, the slope of the increase in potential in the regions of the gate G1_G of the transfer transistor G1 to the gate G6_G of the transfer transistor G6 is steeper than the slope of the increase in potential in the regions of the gate GD1_G of the charge drainage transistor GD1 and the gate GD2_G of the charge drainage transistor GD2.

Therefore, in the present embodiment, as in the first embodiment, the slope of the increase in potential in the transfer transistors G is steeper than the slope of the increase in potential in the charge drainage transistors GD; thus, charge carriers generated by the photoelectric conversion device PD are more easily transferred via the transfer transistors G. This allows the transfer transistors G to transfer charge carriers to the floating diffusions FD at a high speed.

As in the first embodiment, the charge drainage transistors GD, that is, the two charge drainage transistors (GD1, GD2), transfer charge carriers to the drains GD_D over a sufficiently long period of time compared with the transfer transistors G; thus, the charge drainage transistors GD perform the discharging process without problems even when the slope of the increase in potential in the charge drainage transistors GD is more gradual than in the transfer transistors G.

In the present embodiment, the distance from each of the gate G1_G of the transfer transistor G1, the gate G2_G of the transfer transistor G2, the gate G3_G of the transfer transistor G3, the gate G4_G of the transfer transistor G4, the gate G5_G of the transfer transistor G5, and the gate G6_G of the transfer transistor G6 to the x-axis passing through the center O of the photoelectric conversion device PD is the same. Thus, the slope of the change in potential (the slope of the increase in potential) due to the application of a voltage to the gates G1_G, G2_G, G3_G, G4_G, G5_G, and G6_G is the same in these gates, allowing the transfer transistors G1, G2, G3, G4, G5, and G6 to have the same transfer efficiency and the same transfer characteristics. This enables the transfer transistors G1, G2, G3, G4, G5, and G6 to highly accurately transfer charge carriers generated by the photoelectric conversion device PD to the floating diffusions FD1, FD2, FD3, FD4, FD5, and FD6, respectively.

That is, when the transfer transistors G1, G2, G3, G4, G5, and G6 respectively transfer, for example, the same quantity of charge carriers from the photoelectric conversion device PD to the floating diffusions FD1, FD2, FD3, FD4, FD5, and FD6, the same quantity of charge carriers is stored in the floating diffusions FD1, FD2, FD3, FD4, FD5, and FD6.

Therefore, in the present embodiment, charge carriers generated by the photoelectric conversion device PD can be transferred to and stored in the charge storages CS1 to CS6 at the same transfer efficiency (with the same transfer characteristics); thus, the distance between a subject and the range imaging apparatus can be obtained with high accuracy by the formulas (1) to (4) using the quantity of charge carriers stored in the charge storages CS1 to CS6.

In the arrangement shown in Fig. 8, for example, the distance from the transfer transistor G1 to the short side PDS 1 of the photoelectric conversion device PD (photodiode) is the same as the distance from the transfer transistor G3 to the short side PDS2 of the photoelectric conversion device PD. On the other hand, the distance from the transfer transistor G2 to the short sides PDS1 and PDS2 of the photoelectric conversion device PD is different from the distance from the transfer transistors G1 and G3 to the respective short sides PDS1 and PDS2 of the photoelectric conversion device PD.

Thus, the shape of an electric field generated in response to application of a voltage to the gates of the transfer transistors G1 and G3 may be different from the shape of an electric field generated in response to application of a voltage to the gate of the transfer transistor G2, depending on the distance from the transfer transistors G1 and G3 to the respective short sides PDS1 and PDS2 of the photoelectric conversion device PD.

The difference in the shape of the electric field leads to a difference in the slope of the change in potential; thus, the transfer transistors G1 and G3 transfer charge carriers at a transfer efficiency different from that of the transfer transistor G2.

However, by multiplying the quantity of charge carriers transferred by the transfer transistor G2 (the quantity of charge carriers stored in the charge storage CS) by an adjustment factor to match the transfer efficiency of the transfer transistor G2 to the transfer efficiency of the transfer transistors G1 and G3, it is easy to cause the transfer transistors G1, G2, and G3 to have the same transfer efficiency and allow the transfer transistors G1, G2, and G3 to appear to have the same transfer characteristics. The adjustment factor can be easily obtained by a process in which the adjustment factor is obtained by generating the same quantity of charge carriers. Thus, it is easy to cause the transfer transistor G2 to have the same transfer efficiency as the transfer transistors G1 and G3.

This enables charge carriers to be stored with the same characteristics in the charge storages CS1 to CS6; thus, the distance between a subject and the range imaging apparatus can be obtained with high accuracy by the formulas (1) to (4) using the quantity of charge carriers stored in the charge storages CS1 to CS6.

<Third embodiment>

A third embodiment of the present invention will be described with reference to the drawings.

The third embodiment is a range imaging device (range imaging sensor 32) of the range imaging apparatus having the same configuration as that in Fig. 2, and is configured such that the pixel circuits 321 as shown in Fig. 4 are each provided with a condenser microlens.

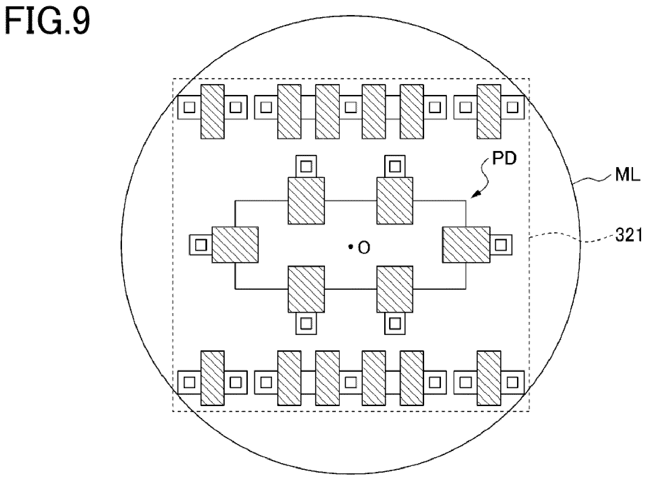

Fig. 9 is a diagram showing a positional relationship between the photoelectric conversion device PD and a microlens ML of the pixel circuits 321.

Microlenses ML are formed by thermal shaping of a predetermined resin material, and are provided to overlap in plan view with the regions in which the pixel circuits 321 are arranged.

The microlenses ML are provided in the respective pixel circuits 321 so that the optical axes of the microlenses ML (the center of the microlenses ML) overlap with the center O of the photoelectric conversion devices PD in plan view.

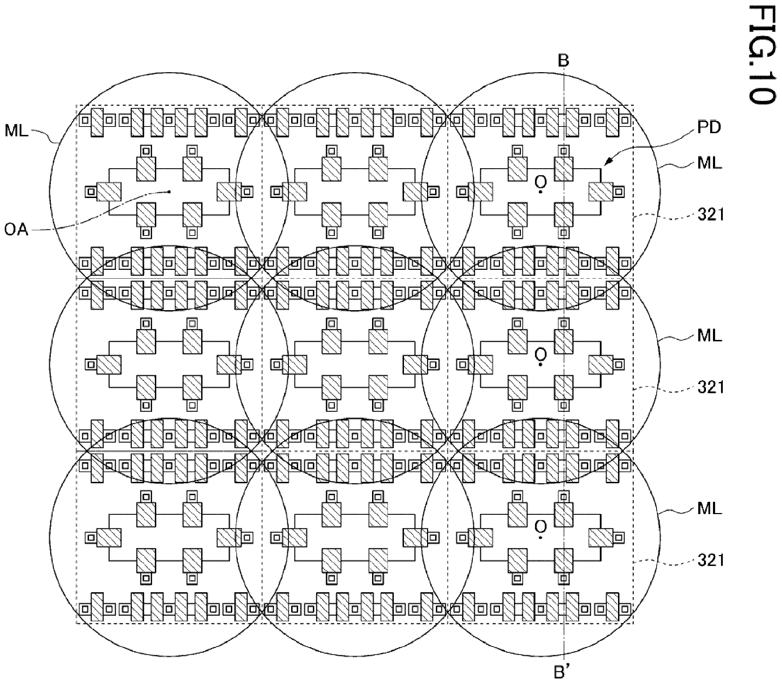

Fig. 10 is a plan view showing a lens array in a portion of the light receiving region 320 in which the plurality of pixel circuits 321 are arranged.

Fig. 10 shows a positional relationship between the pixel circuits 321 and the microlenses ML that are arranged as a lens array in a portion of the light receiving region 320 with a 3 × 3 matrix of pixel circuits 321.

The optical axis of each of the microlenses ML of the microlens array overlaps with the center O of one of the pixel circuits 321 that overlaps with the corresponding one of the microlenses ML in plan view.

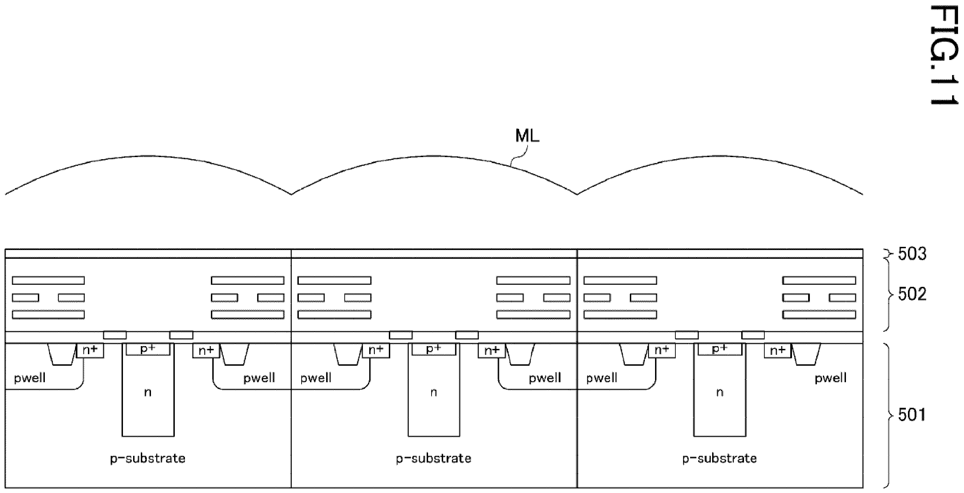

Fig. 11 is a cross-sectional view of the lens array of the pixel circuits 321 provided with the microlenses ML in Fig. 10.

Fig. 11 shows the shape of a cross section of the lens array of the pixel circuits 321 taken along line segment B-B' in Fig. 10. The range imaging sensor 32 as a range imaging device in Fig. 11 is an FSI (front side illumination) sensor in which light is incident on a surface provided with photodiodes which are the photoelectric conversion devices PD.

A wiring layer 502 that is insulated by an insulating layer is provided above a semiconductor layer 501, and a dielectric layer 503 as a passivation layer is provided above the wiring layer 502. The lens array of the microlenses ML (microlens array) is provided above the dielectric layer 503.

An optical axis OA of each of the microlenses ML of the microlens array is perpendicular to a surface of the photoelectric conversion device PD in the semiconductor layer 501, and passes through the center O of one of the pixel circuits 321 that overlaps with the corresponding one of the microlenses ML in plan view.

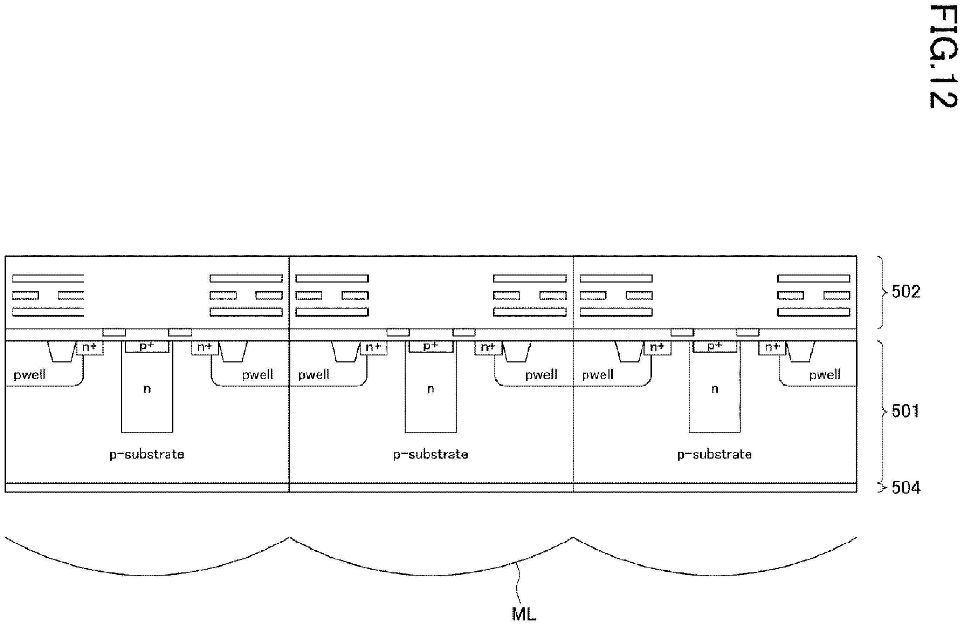

Fig. 12 is a cross-sectional view of the lens array of the pixel circuits 321 provided with the microlenses ML in Fig. 10.

Fig. 12 shows the shape of a cross section of the lens array of the pixel circuits 321 taken along line segment B-B' in Fig. 10. The range imaging sensor 32 as a range imaging device in Fig. 12 is a BSI (back side illumination) sensor in which light is incident on a back surface provided with photodiodes which are the photoelectric conversion devices PD. That is, although a front side illumination type is used as the configuration of the pixel circuits 321 in Fig. 11, as shown in Fig. 12, a back side illumination type may be used as the configuration of the pixel circuits 321.

A wiring layer 502 that is insulated by an insulating layer is provided above the semiconductor layer 501, and a dielectric layer 504 as a passivation layer is provided below the semiconductor layer 501. The lens array of the microlenses ML is provided below the dielectric layer 504.

The optical axis OA of each of the microlenses ML of the lens array is perpendicular to a surface of the photoelectric conversion device PD in the semiconductor layer 501, and passes through the center O of one of the pixel circuits 321 that overlaps with the corresponding one of the microlenses ML in plan view.

With the configuration described above, in the present embodiment, the microlenses ML allow light incident on the pixel circuits 321 to be condensed and incident on the photoelectric conversion devices PD, and this enables efficient photoelectric conversion of the light incident on the pixel circuits 321, achieving higher sensitivity to the incident light.

In the present embodiment, the arrangement of the microlenses ML with respect to the pixel circuits 321 of the first embodiment is described; however, by arranging the microlenses ML with respect to the pixel circuits 321 of the second embodiment in the same manner, it is possible to allow the pixel circuits 321 of the second embodiment to have higher sensitivity to incident light.

[Industrial Applicability]

As described above, the present invention provides a range imaging device and a range imaging apparatus in which transfer gates for transferring charge carriers from a photoelectric conversion device to charge storages have the same transfer characteristics, charge carriers generated by the photoelectric conversion device are transferred to the charge storages at the same transfer efficiency, and a distance measured from the charge carriers stored in the charge storages is obtained with higher accuracy.

[Reference Signs List]

1 ... Range imaging apparatus
2 ... Light source unit
3 ... Light receiving unit
31 ... Lens
32 ... Range imaging sensor (range imaging device)
321 ... Pixel circuit
322 ... Control circuit
323 ... Vertical scanning circuit
324 ... Horizontal scanning circuit
325 ... Pixel signal processing circuit
4 ... Distance image processing unit
41 ... Timing controller
42 ... Distance calculator
CS ... Charge storage
FD1, FD2, FD3, FD4, FD5, FD6 ... Floating diffusion
G1, G2, G3, G4, G5, G6 ... Transfer transistor
GD1, GD2 ... Charge drainage transistor
ML ... Microlens
PD ... Photoelectric conversion device
PO ... Light pulse
RT1, RT2, RT3, RT4, RT5, RT6 ... Reset transistor
S ... Subject
SF1, SF2, SF3, SF4, SF5, SF6 ... Source follower transistor
SL1, SL2, SL3, SL4, SL5, SL6 ... Selection transistor

**Claims**

1. A range imaging device comprising:

    a semiconductor substrate; and
    a pixel circuit (321) formed at a surface of the semiconductor substrate, the pixel circuit including at least:

        a photoelectric conversion device (PD) configured to generate charge carriers based on light incident from a space targeted for measurement;
        charge storages (CS1, CS2, CS3, CS4) each configured to store at least some of the generated charge carriers;
        at least one transfer MOS transistor (G1) provided on a transfer path, the at least one transfer MOS transistor being configured to transfer at least some of the generated charge carriers from the photoelectric conversion device to a corresponding one of the charge storages through the transfer path; and
        at least one charge drainage MOS transistor provided on a drainage path, the at least one charge drainage MOS transistor being configured to drain the generated charge carriers from the photoelectric conversion device through the drainage path,

        wherein:

        the photoelectric conversion device has a rectangular shape in plan view on the surface of the photoelectric conversion device; **characterised in that**
        the at least one transfer MOS transistor comprises 2M transfer MOS transistors, and the at least one charge drainage MOS transistor comprises 2N charge drainage MOS transistors, M being an integer greater than or equal to 2, N being an integer greater than or equal to 1;
        M transfer MOS transistors of the 2M transfer MOS transistors are arranged on each of long sides of the photoelectric conversion device symmetrically with respect to an x-axis that is parallel to the long sides and passes through a center of the photoelectric conversion device, the M transfer MOS transistors on one of the long sides facing the M transfer MOS transistors on the other of the long sides; and
the 2N charge drainage MOS transistors are provided on respective short sides of the photoelectric conversion device.

**2.** The range imaging device according to claim 1, wherein:
the transfer MOS transistors are arranged symmetrically with respect to a y-axis that is parallel to the short sides and passes through the center of the photoelectric conversion device.

**3.** The range imaging device according to claim 1 or 2, wherein:
the charge storages are arranged symmetrically with respect to the x-axis.

**4.** The range imaging device according to any one of claims 1 to 3, further comprising:
a microlens (ML) facing a surface of the pixel circuit, the surface of the pixel circuit being arranged to receive the light, the microlens having an optical axis that is perpendicular to an entrance surface of the photoelectric conversion device and passes through a center of the entrance surface, the entrance surface being arranged to receive the light.

**5.** A range imaging apparatus comprising:

a light receiving unit including the range imaging device according to any one of claims 1 to 4; and
a distance image processing unit (4) configured to obtain a distance from the range imaging device to a subject based on a distance image captured by the range imaging device.

**Patentansprüche**

**1.** Entfernungsbildaufnahmevorrichtung, umfassend:

ein Halbleitersubstrat; und
einen Pixelschaltkreis (321), welcher an einer Fläche des Halbleitersubstrats gebildet ist, wobei der Pixelschaltkreis wenigstens umfasst:

eine photoelektrische Umwandlungsvorrichtung (PD), welche dazu eingerichtet ist, Ladungsträger basierend auf Licht zu generieren, welches von einem Raum einfällt, welcher zur Messung anvisiert ist;
Ladungsspeicher (CS1, CS2, CS3, CS4), welche jeweils dazu eingerichtet sind, wenigstens manche der generierten Ladungsträger zu speichern;
wenigstens einen Übertragungs-MOS-Transistor (G1), welcher an einem Übertragungspfad bereitgestellt ist, wobei der wenigstens eine Übertragungs-MOS-Transistor dazu eingerichtet ist, wenigstens manche der generierten Ladungsträger von der photoelektrischen Umwandlungsvorrichtung zu einem entsprechenden der Ladungsspeicher durch den Übertragungspfad zu übertragen; und
wenigstens einen Ladungsabfluss-MOS-Transistor, welcher an einem Abflusspfad bereitgestellt ist, wobei der wenigstens eine Ladungsabfluss-MOS-Transistor dazu eingerichtet ist, die generierten Ladungsträger von der photoelektrischen Umwandlungsvorrichtung durch den Abflusspfad abfließen zu lassen,

wobei:

die photoelektrische Umwandlungsvorrichtung in einer Draufsicht auf die Fläche der photoelektrischen Umwandlungsvorrichtung eine rechteckige Gestalt aufweist;
**dadurch gekennzeichnet, dass**
der wenigstens eine Übertragungs-MOS-Transistor 2M Übertragungs-MOS-Transistoren umfasst, und der wenigstens eine Ladungsabfluss-MOS-Transistor 2N Ladungsabfluss-MOS-Transistoren umfasst, wobei M eine Ganzzahl größer als oder gleich wie 2 und N eine Ganzzahl größer als oder gleich wie 1 ist;
M Übertragungs-MOS-Transistoren der 2M Übertragungs-MOS-Transistoren an jeder von langen Seiten der photoelektrischen Umwandlungsvorrichtung symmetrisch angeordnet sind in Bezug auf eine X-Achse, welche parallel zu den langen Seiten ist und durch eine Mitte der photoelektrischen Umwandlungsvorrichtung verläuft, wobei die M Übertragungs-MOS-Transistoren an einer der langen Seiten zu M Übertragungs-MOS-Transistoren an der anderen der langen Seiten ausgerichtet sind; und
die 2N Ladungsabfluss-MOS-Transistoren an entsprechenden kurzen Seiten der photoelektrischen Umwandlungsvorrichtung angeordnet sind.

**2.** Entfernungsbildaufnahmevorrichtung nach Anspruch 1, wobei:
die Übertragungs-MOS-Transistoren symmetrisch angeordnet sind in Bezug auf eine Y-Achse, welche parallel zu den kurzen Seiten ist und durch die Mitte der photoelektrischen Umwandlungsvorrichtung verläuft.

**3.** Entfernungsbildaufnahmevorrichtung nach Anspruch 1 oder 2, wobei:
die Ladungsspeicher symmetrisch angeordnet sind in Bezug auf die X-Achse.

**4.** Entfernungsbildaufnahmevorrichtung nach einem der Ansprüche 1 bis 3, ferner umfassend:
eine Mikrolinse (ML), welche zu einer Fläche des Pixelschaltkreises ausgerichtet ist, wobei die Fläche des Pixelschaltkreises angeordnet ist, um das Licht zu empfangen, wobei die Mikrolinse eine optische Achse aufweist, welche senkrecht zu einer Eingangsfläche der photoelektrischen Umwandlungsvorrichtung ist und durch eine Mitte der Eingangsfläche verläuft, wobei die Eingangsfläche angeordnet ist, um das Licht zu empfangen.

**5.** Entfernungsbildaufnahmegerät, umfassend:

eine lichtempfangende Einheit, welche die Entfernungsbildaufnahmevorrichtung nach einem der Ansprüche 1 bis 4 umfasst; und
eine Entfernungsbildverarbeitungseinheit (4), welche dazu eingerichtet ist, eine Entfernung von der Entfernungsbildaufnahmevorrichtung zu einem Subjekt basierend auf einem Entfernungsbild zu erhalten, welches durch die Entfernungsbildaufnahmevorrichtung aufgenommen ist.

**Revendications**

**1.** Dispositif d'imagerie télémétrique comprenant :

un substrat semi-conducteur ; et
un circuit de pixel (321) formé au niveau d'une surface du substrat semi-conducteur, le circuit pixel comportant au moins :

un dispositif de conversion photoélectrique (PD) configuré pour générer des porteurs de charge sur la base d'une lumière incidente à partir d'un espace ciblé pour une mesure ;
des stockages de charge (CS1, CS2, CS3, CS4), configurés chacun pour stocker au moins certains des porteurs de charge générés ;
au moins un transistor à métal-oxyde-semi-conducteur, MOS, de transfert (G1) ménagé sur un chemin de transfert, l'au moins un transistor MOS de transfert étant configuré pour transférer au moins certains des porteurs de charge générés, du dispositif de conversion photoélectrique à un stockage de charge correspondant parmi les stockages de charge par le biais du chemin de transfert ; et
au moins un transistor MOS de drainage de charge ménagé sur un chemin de drainage, l'au moins un transistor MOS de drainage de charge étant configuré pour drainer les porteurs de charge générés provenant du dispositif de conversion photoélectrique par le biais du chemin de drainage,
dans lequel :

le dispositif de conversion photoélectrique possède une forme rectangulaire en vue en plan sur la surface du dispositif de conversion photoélectrique ;
**caractérisé en ce que**
l'au moins un transistor MOS de transfert comprend 2M transistors MOS de transfert, et l'au moins un transistor MOS de drainage de charge comprend 2N transistors MOS de drainage de charge, M étant un nombre entier supérieur à ou égal à 2, N étant un nombre entier supérieur à ou égal à 1 ;
M transistors MOS de transfert parmi les 2M transistors MOS de transfert sont agencés sur chacun des côtés longs du dispositif de conversion photoélectrique de manière symétrique par rapport à un axe x qui est parallèle aux côtés longs et passe par un centre du dispositif de conversion photoélectrique, les M transistors MOS de transfert sur l'un des côtés longs faisant face aux M transistors MOS de transfert sur l'autre des côtés longs ; et
les 2N transistors MOS de drainage de charge sont ménagés sur les côtés courts respectifs du dispositif de conversion photoélectrique.

**2.** Dispositif d'imagerie télémétrique selon la revendication 1, dans lequel :

les transistors MOS de transfert sont agencés de manière symétrique par rapport à un axe y qui est parallèle aux côtés courts et passe par le centre du dispositif de conversion photoélectrique.

3. Dispositif d'imagerie télémétrique selon la revendication 1 ou 2, dans lequel :
les stockages de charge sont agencés de manière symétrique par rapport à l'axe x.

4. Dispositif d'imagerie télémétrique selon l'une quelconque des revendications 1 à 3, comprenant en outre :
une microlentille (ML) faisant face à une surface du circuit de pixel, la surface du circuit de pixel étant agencée pour recevoir la lumière, la microlentille ayant un axe optique qui est perpendiculaire à une surface d'entrée du dispositif de conversion photoélectrique et passe par un centre de la surface d'entrée, la surface d'entrée étant agencée pour recevoir la lumière.

5. Appareil d'imagerie télémétrique comprenant :

une unité de réception de lumière comportant le dispositif d'imagerie télémétrique selon l'une quelconque des revendications 1 à 4 ; et
une unité de traitement d'image de distance (4) configurée pour obtenir une distance du dispositif d'imagerie télémétrique à un sujet sur la base d'une image de distance capturée par le dispositif d'imagerie télémétrique.

# FIG.1

FIG.2

# FIG.3

# FIG.4

321

# FIG.5

FIG.6A

FIG.6B

FIG.7A

# FIG.7B

# FIG.8

FIG.9

# FIG.10

# FIG.11

# FIG.12

502

501

504

ML

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020180563 A
- WO 2020196023 A1
- JP 4235729 B